# EUROPÄISCHE PATENTSCHRIFT

(11) **EP 0 681 368 B1**
(45) Veröffentlichungstag und Bekanntmachung des Hinweises auf die Patenterteilung: **15.12.1999**
(21) Anmeldenummer: 95106851.9
(22) Anmeldetag: 05.05.1995
(51) Int. Cl.: H03F 3/45

(54) **Operationsverstärker mit hoher Gleichtaktunterdrückung**
Operational amplifier with high common-mode rejection
Amplificateur opérationnel à taux élevé de rejection de mode commun

(30) Priorität: 05.05.1994 DE 4415953
(43) Veröffentlichungstag der Anmeldung: 08.11.1995
(73) Patentinhaber: SIEMENS AKTIENGESELLSCHAFT, 80333 München (DE)
(72) Erfinder: Veit, Werner, D-82008 Unterhaching (DE); Irvine, Robert-Grant, D-81543 München (DE)

(56) Entgegenhaltungen:
- US-A- 4 742 308
- US-A- 5 298 809
- INSTRUMENTS AND EXPERIMENTAL TECHNIQUES, Bd. 23, Nr. 2, März 1980 NEW YORK US, Seiten 428-429, A.S. NAGAIKIN ET AL 'WIDEBAND DC AMPLIFIER'
- IEEE JOURNAL OF SOLID-STATE CIRCUITS, Bd. 25, Nr. 6, Dezember 1990 NEW YORK US, Seiten 1575-1585, XP 000176589 R. CASTELLO ET AL 'ANALOG FRONT END OF AN ECBM TRANSCEIVER FOR ISDN'
- IEEE TRANSACTIONS ON CIRCUITS AND SYSTEMS I: FUNDAMENTAL THEORY AND APPLICATIONS Bd. 39, Nr. 8, NEW YORK US, Seiten 614 - 627, XP368411 G. GROENEWOLD: 'OPTIMAL DYNAMIC RANGE INTEGRATORS'

## Beschreibung

Die Erfindung betrifft einen Operationsverstärker mit symmetrischen Eingängen und symmetrischen Ausgängen.

Diesen Operationsverstärkern werden symmetrische Eingangssignale zugeführt, d. h. Eingangssignale, die in ihrem Betrag übereinstimmen, bezogen auf einen Referenzwert jedoch entgegengesetzte Vorzeichen aufweisen. Die an den symmetrischen Ausgängen eines derartigen Operationsverstärkers anliegenden Ausgangssignale sollten dementsprechend gleiche Amplituden mit entgegengesetzten Vorzeichen aufweisen. Das bedeutet, daß die Summe beider Signale immer möglichst gleich Null sein sollte, was einer maximalen Gleichtaktunterdrückung entspricht.

Ein derartiger Operationsverstärker ist aus dem deutschen Gebrauchsmuster G 92 07 812.5 bekannt. Die darin beschriebene Schaltungsanordnung ist für eine Versorgungsspannung von minimal 4,5 Volt ausgelegt. Modernere Schaltungsanordnungen verlangen jedoch insbesondere in mobilen Anwendungen eine minimale Versorgungsspannung von 2,7 Volt. Da die bekannte Verstärkerschaltung für 4,5 Volt ausgelegt ist, enthält sie Kaskodestufen für hohe Leerlaufverstärkung und niederohmige "Pushpull"-Ausgangspufferverstärker. Diese Schaltungsteile stehen einem Betrieb bei 2,7 Volt im Wege, da die Anordnung bis zu 4 Diodenschwellspannungen aufsummiert.

Aus dem Stand der Technik US 4,742,308 ist ein differentieller Operationsverstärker gemäß dem Oberbegriff des Patentanspruchs 1 bekannt, der eine Eingangs- und eine Ausgangsstufe aufweist. Der Operationsverstärker hat durch eine Gleichtaktrückkopplung keinen Gleichtaktanteil im Ausgangssignal am Ausgang des Operationsverstärkers. Dazu beinhaltet die Schaltung einen Gleichtaktdetektor, der zur Detektion des Gleichtaktsignalanteils am Ausgang der Ausgangsstufe vorgesehen ist. Weiterhin sind zwei Stromsteuereinrichtungen vorgesehen, die gleiche Ströme von jedem der Ausgänge der Eingangsstufe erzeugen. Der Gleichtaktdetektor koppelt das Steuersignal auf die Stromsteuereinrichtungen zurück, wobei der Gleichtaktanteil an den Ausgängen annähernd unterdrückt wird. Für den Einsatz bei einer Betriebsspannung von 2,7 Volt ist diese Schaltungsanordnung nicht geeignet.

Aus dem Stand der Technik US 5,298,809 ist ein Differenzverstärker mit zwei differentiellen Ausgängen bekannt. Dies ist jedoch ebenfalls nicht für den Betrieb bei niedrigen Versorgungsspannungen, d. h. bei 2,7 Volt geeignet.

Aufgabe der vorliegenden Erfindung ist es daher, einen Operationsverstärker anzugeben, der bei einer hohen Gleichtaktunterdrückung eine niedrigere Versorgungsspannung aufweist.

Diese Aufgabe wird durch einen Operationsverstärker gemäß den Anspruch 1 gelöst. Ausgestaltungen und Weiterbildungen eines derartigen Operationsverstärkers sind Gegenstand von Unteransprüchen.

Insbesondere für Filteranwendungen bei tiefen Frequenzen ist es vorteilhafterweise möglich, auf die Kaskodestufe zu verzichten und die Pushpull-Pufferverstärker durch Emitterfolger zu ersetzen, ohne daß ein Performanceverlust auftritt.

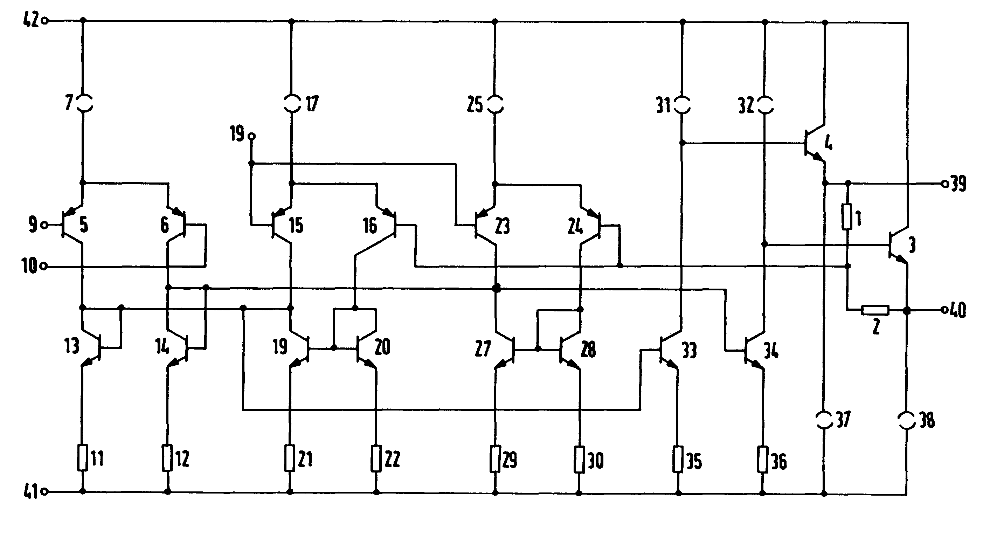

Die Erfindung wird nachfolgend anhand des in der einzigen Figur der Zeichnung dargestellten Ausführungsbeispiels näher erläutert.

Bei dem als Ausführungsbeispiel gezeigten Operationsverstärker sind als symmetrische Endstufe zwei Emitterfolger 3, 4 vorgesehen, deren Emitter jeweils mit Ausgangsanschlüssen 39, 40 verbunden sind, die die Ausgänge des Operationsverstärkers bilden. Diese Emitterfolger ersetzen die bekannten "Pushpull"- Ausgangspufferverstärker. Zwischen die Ausgangsanschlüsse der beiden Emitterfolger 3, 4 ist ein aus zwei in Reihe geschalteten Widerständen 1, 2 bestehender Spannungsteiler geschaltet. Die Widerstände 1, 2 weisen identische Widerstandswerte auf, so daß der Teilungsfaktor des Spannungsteilers gleich 0,5 ist. Neben der gezeigten ohmschen Spannungsteilung können darüber hinaus auch bei bestimmten Anwendungen, insbesondere zur Frequenzkompensation auch Spannungsteiler mit induktiven oder kapazitiven Anteilen vorgesehen werden. Die Emitterfolger sind jeweils emitterseitig über je eine Stromquelle 37, 38 mit einer ersten Versorgungsspannungsklemme 41 verbunden. Die Kollektoren der Emitterfolger 3, 4 sind jeweils mit einer weiteren Versorgungsspannungsklemme 42 verschaltet. Die Basisanschlüsse der beiden Emitterfolger 3, 4 sind jeweils über eine Stromquelle 31, 32 mit dem positiven Versorgungspotential 42 gekoppelt und zum anderen mit dem Kollektor eines npn-Transistors 33, 34 verbunden. Die Emitter der beiden Transistoren 33, 34 sind über jeweils einen Widerstand 35, 36 auf das negatives Versorgungspotential 41 geführt. Die Basen der beiden Transistoren 33, 34 sind jeweils mit Basis und Kollektor eines npn-Transistors 13, 14 verbunden, deren Emitter widerum über jeweils einen Widerstand 11, 12 mit dem negativen Versorgungspotential 41 verschaltet sind. Die miteinander verbundenen Basen und Kollektoren der npn-Transistoren 13, 14 sind zudem mit dem Kollektor jeweils eines pnp-Transistors 5, 6 verbunden. Die Emitter der beiden pnp-Transistoren 5, 6 sind miteinander sowie über eine Stromquelle 7 an das positive Versorgungspotential 42 angeschlossen.

Des weiteren ist der Kollektor des pnp-Transistors 5 mit den Kollektoren eines pnp-Transistors 15 und eines npn-Transistors 19 verbunden. Parallel zum Transistor 15 ist ein pnp-Transistor 16 vorgesehen, dessen Kollektor mit einem npn-Transistor 20 verbunden ist. Die Emitter der Transistoren 19 und 20 sind jeweils über einen Widerstand 21, 22 an das negative Versorgungspotential 41 angeschlossen. Die Basisanschlüsse der npn-Transistoren 19, 20 sind miteinander und mit dem Kollektor des Transistors 20 verschaltet. Die Emitter der pnp-Transistoren 15, 16 sind miteinander und über eine Stromquelle 17 an das positive Versorgungspotential 42 angekoppelt. An der Basis des pnp-Transistors 15 liegt dabei ein Referenzpotential 19 an.

Des weiteren ist die Basis des pnp-Transistors 15 an die Basis eines weiteren pnp-Transistors 23 angeschlossen. Die Basis des Transistors 16 ist ebenso an die Basis eines weiteren pnp-Transistors 24 gekoppelt. Die beiden Emitter der Transistoren 23 und 24 sind miteinander und über eine Stromquelle 25 an das positive Versorgungspotential 42 gekoppelt. Der Kollektor des Transistors 23 ist zum einen mit dem Kollektor des Transistors 14 und zum anderen mit dem Kollektor eines weiteren npn-Transistors 27 verschaltet. Der Kollektor des pnp-Transistors 24 ist mit dem Kollektor eines weiteren npn-Transistors 28 gekoppelt. Die Basisanschlüsse der npn-Transistoren 27 und 28 sind miteinander und mit dem Kollektor des Transistors 28 verschaltet. Die beiden Emitteranschlüsse der Transistoren 27 und 28 sind jeweils über einen Widerstand 29 und 30 an das negative Versorgungspotential 41 gekoppelt. Schließlich ist die Basis des pnp-Transistors 16 mit dem Abgriff des Spannungsteilers bildenden Knotenpunkt zwischen den Widerständen 1 und 2 verbunden.

Bei dem erfindungsgemäßen Operationsverstärker wird mittels des Spannungsteilers ein Mittelwert der an den Ausgängen 39, 40 anliegenden symmetrischen Spannung gebildet, der in einer zweiten Differenzverstärkerstufe bestehend aus zwei parallel geschalteten Differenzverstärkern 15 bis 22 und 23 bis 30 mit einem Referenzwert an der Eingangsklemme 19 verglichen wird. Diese Differenzverstärkerstufe besteht im vorliegenden Ausführungsbeispiel im wesentlichen aus den beiden pnp-Transistoren 15, 16, sowie der zugehörigen Stromquellen 17. Die parallel geschaltete zweite Verstärkerstufe besteht aus den beiden pnp-Transistoren 23, 24 und der zugehörigen Stromquelle 25. Einer ersten Differenzverstärkerstufe, die beispielsweise der zuvor genannten entspricht, die im wesentlichen durch die pnp-Transistoren 5, 6 und die Stromquelle 7 gebildet wird, wird über die Eingänge 9, 10 ein symmetrisches Eingangssignal zugeführt. Diese Differenzverstärkerstufe ist durch eine Last abgeschlossen. Die Last wird im vorliegenden Fall durch zwei Stromspiegel gebildet, die jeweils mit einem Ausgangsanschluß der ersten Differenzverstärkerstufe gekoppelt sind. Die beiden Stromspiegel bilden dabei jeweils eine Last, die den eigentlichen Differenzverstärkerausgang abschließt. Diese Last ist zum einen der Stromspiegel mit den npn-Transistoren 13, 33 sowie dem Widerstand 12, 11, 35 und zum anderen der Stromspiegel mit den npn-Transistoren 14, 34 sowie den Widerständen 12, 36. Außer zur Erzeugung der Last dienen die beiden Stromspiegel darüber hinaus in Verbindung mit den Stromquellen 31, 32 zur Signalauskopplung für die beiden Emitterfolger 3, 4, wobei die Transistoren 33 und 34 die Signale über die Lasten invertieren und verstärken. Die zweite Differenzverstärkerstufe ist nun jeweils mit einem Stromzweig der beiden parallel geschalteten Differenzverstärkerstufen gekoppelt. Hierbei wirkt jeweils ein Stromzweig der ersten Differenzverstärkerstufe auf einen der beiden parallel geschalteten Differenzverstärker. Dazu wird der durch den pnp-Transistor 5 bzw. 6 fließende Strom jeweils in den Eingangskreis der Stromspiegel eingespeist.

Die erste Differenzverstärkerstufe weist ebenso wie die beiden parallel geschalteten Differenzverstärkerstufen emittergekoppelte pnp-Transistoren 5, 6 bzw. 15, 16; 23, 24 auf, deren Versorgungströme über jeweils eine Stromquelle 7, 8, 17, 18, 25, 36 gespeist werden. Vorzugsweise können die Stromquellen 7, 8, 17, 18, 25, 26 sowie die Stromquellen 31, 32 eine Strombank in bekannter Weise bilden.

Im übrigen ist die prinzipielle Funktionsweise des erfindungsgemäßen voll differentiellem Operationsverstärkers gleich mit der in dem deutschen Gebrauchsmuster G 92 07 812.5 beschriebenen, kann jedoch mit einer wesentlich niedrigeren Versorgungsspannung betrieben werden.

## Patentansprüche

1. Operationsverstärker mit einem Spannungsteiler (1, 2), der zwischen die Ausgänge des Operationsverstärkers bildende Ausgangsanschlüsse (39, 40) einer symmetrischen Endstufe (3, 4) geschaltet ist, mit einer ersten Differenzverstärkerstufe (5 bis 7), deren Eingangsanschlüsse die symmetrischen Eingänge (9, 10) des Operationsverstärkers bilden und deren Ausgangsanschlüsse zum einen jeweils mit einer Last (11 bis 14) abgeschlossen und zum anderen mit jeweils einem Eingangsanschluß der Endstufe (3, 4) gekoppelt sind, mit zwei weiteren parallel geschalteten Differenzverstärkerstufen (15 bis 17; 23 bis 25), deren erste Eingangsanschlüsse jeweils an ein Referenzpotential (19) und deren jeweiliger anderer Eingangsanschluß an den Abgriff des Spannungsteilers angeschlossen ist und deren jeweils einer Ausgangsanschluß mit der Last (11 bis 14) gekoppelt ist, **dadurch gekennzeichnet**, daß die symmetrische Endstufe durch jeweils einen Emitterfolger (3, 4) gebildet wird, und
daß als Lasten (11 bis 14) die Eingangskreise zweier Stromspiegel (11, 13, 33, 35; 12, 14, 34, 36) vorgesehen sind, deren Ausgangskreise jeweils zum einen mit einer Stromquelle (31; 32) und zum anderen mit einem der Eingangsanschlüsse der Endstufe (3, 4) verbunden sind.

2. Operationsverstärker nach Anspruch 1, **dadurch gekennzeichnet**, daß den Lasten (11 bis 14) jeweils ein Ausgangskreis eines weiteren Stromspiegels (19 bis 22; 27 bis 30) parallel geschaltet ist, die jeweils im Ausgangskreis der parallel geschalteten Differenzverstärker (15 bis 17; 23 bis 25) geschaltet sind.

3. Operationsverstärker nach einem der vorhergehenden Ansprüche, **dadurch gekennzeichnet**, daß mindestens eine Differenzverstärkerstufe (5 bis 7; 15 bis 17; 23 bis 25) ein aus einer Stromquelle (7; 17, 25) gespeistes, emittergekoppeltes bipolares Transistorpaar aufweist.

4. Operationsverstärker nach Anspruch 3, **dadurch gekennzeichnet**, daß die Stromquellen (7, 17, 25, 31, 32) durch eine Strombank gebildet werden.

## Claims

1. Operational amplifier having a voltage divider (1, 2), which is connected between output connections (39, 40) (which form the outputs of the operational amplifier) of a balanced output stage (3, 4), having a first differential amplifying stage (5 to 7) whose input connections form the balanced inputs (9, 10) of the operational amplifier and whose output connections are on the one hand in each case terminated by a load (11 to 14) and are on the other hand coupled to in each case one input connection of the output stage (3, 4), having two further parallel-connected differential amplifier stages (15 to 17; 23 to 25), whose first input connections are in each case connected to a reference potential (19) and whose respective other input connection is connected to the tap of the voltage divider, and whose respective one output connection is coupled to the load (11 to 14), **characterized** in that the balanced output stage is in each case formed by an emitter follower (3, 4), and
in that the input circuits of two balanced circuits (11, 13, 33, 35; 12, 14, 34, 36) are provided as the loads (11 to 14) and their output circuits are in each case connected on the one hand to a current source (31; 32) and on the other hand to one of the input connections of the output stage (3, 4).

2. Operational amplifier according to Claim 1, **characterized** in that an output circuit of a further balanced circuit (19 to 22; 27 to 30) is connected in parallel with each of the loads (11 to 14), which output circuits are each connected in the output circuit of the parallel-connected differential amplifiers (15 to 17; 23 to 25).

3. Operational amplifier according to one of the preceding claims, **characterized** in that at least one differential amplifier stage (5 to 7; 15 to 17; 23 to 25) has an emitter-coupled bipolar transistor pair, fed from a current source (7; 17, 25).

4. Operational amplifier according to Claim 3, **characterized** in that the current sources (7, 17, 25, 31, 32) are formed by an electrical power supply.

## Revendications

1. Amplificateur opérationnel comportant un diviseur de tension (1, 2) qui est branché entre des bornes de sortie (39, 40), formant les sorties de l'amplificateur opérationnel, d'un étage terminal symétrique (3, 4), un premier étage amplificateur différentiel (5 à 7) dont les bornes d'entrée forment les entrées symétriques (9, 10) de l'amplificateur opérationnel et dont les bornes de sortie sont fermées d'une part respectivement par une charge (11 à 14) et sont reliées d'autre part respectivement à une borne d'entrée de l'étage terminal (3, 4), deux autres étages amplificateurs différentiels branchés en parallèle (15 à 17; 23 à 25) dont une première borne d'entrée est reliée respectivement à un potentiel de référence (19) et dont une deuxième borne d'entrée est reliée respectivement à la prise du diviseur de tension et dont une borne de sortie est reliée respectivement à la charge (11 à 14), **caractérisé par** le fait que l'étage terminal symétrique est formé respectivement par un émetteur-suiveur (3, 4) et
qu'il est prévu comme charges (11 à 14) les circuits d'entrée de deux miroirs de courant (11, 13, 33, 35 ; 12, 14, 34, 36) dont les circuits de sortie sont reliés respectivement d'une part à une source de courant (31 ; 32) et d'autre part à l'une des bornes d'entrée de l'étage terminal (3, 4).

2. Amplificateur opérationnel selon la revendication 1, **caractérisé par** le fait qu'il est branché en parallèle avec les charges (11 à 14) respectivement un circuit de sortie d'un autre miroir de courant (19 à 22 ; 27 à 30), lesquels miroirs de courant sont branchés respectivement dans le circuit de sortie des amplificateurs différentiels branchés en parallèle (15 à 17; 23 à 25).

3. Amplificateur opérationnel selon l'une des revendications précédentes, **caractérisé par** le fait qu'au moins un étage amplificateur différentiel (5 à 7; 15 à 17; 23 à 25) comporte une paire de transistors bipolaires couplés par les émetteurs et alimentés par une source de courant (7 ; 17 ; 25).

4. Amplificateur opérationnel selon la revendication 3, **caractérisé par** le fait que les sources de courant (7, 17, 25, 31, 32) sont formées par un banc de courant.
